(19) **Europäisches Patentamt / European Patent Office / Office européen des brevets**

(11) **EP 4 733 457 A1**

(12) **EUROPEAN PATENT APPLICATION**
published in accordance with Art. 153(4) EPC

(43) Date of publication:
**29.04.2026 Bulletin 2026/18**

(21) Application number: **24871422.2**

(22) Date of filing: **27.06.2024**

(51) International Patent Classification (IPC):
*D03D 15/267* (2021.01)   *C08J 5/24* (2006.01)
*D03D 1/00* (2006.01)     *D03D 15/41* (2021.01)
*D06M 13/203* (2006.01)   *D06M 13/513* (2006.01)
*H05K 1/03* (2006.01)

(52) Cooperative Patent Classification (CPC):
C08J 5/24; D03D 1/00; D03D 15/267; D03D 15/41;
D06M 13/203; D06M 13/513; H05K 1/03

(86) International application number:
**PCT/JP2024/023361**

(87) International publication number:
**WO 2025/069618 (03.04.2025 Gazette 2025/14)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.09.2023 JP 2023168444**

(71) Applicant: **ASAHI KASEI KABUSHIKI KAISHA Tokyo 100-0006 (JP)**

(72) Inventor: **HIROSE, Amane Tokyo 100-0006 (JP)**

(74) Representative: **Hoffmann Eitle Patent- und Rechtsanwälte PartmbB Arabellastraße 30 81925 München (DE)**

(54) **GLASS CLOTH, PREPREG, PRINTED WIRING BOARD, ETC**

(57)    The present disclosure relates to a glass fabric having a glass yarn as a warp yarn and a weft yarn. The number of twists of the weft yarn is 0.40-1.80 times/25 mm or -1.80-0.40 times/25 mm, an absolute value difference in the number of twists of the warp yarn and the weft yarn is 0.01-0.70 times/25 mm, and the amount of bowed filling of the weft yarn is at most 35 mm.

EP 4 733 457 A1

**Description**

TECHNICAL FIELD

The present invention relates to a glass fabric, a prepreg, a printed circuit board, and the like.

BACKGROUND ART

Currently, the performance of information terminals such as smartphones is improving, and high-speed communication typified by 5G communication is advancing. In association with this, in printed circuit boards for high-speed communication, not only reductions in the dielectric constant and the dielectric loss tangent of insulating materials used for reducing the transmission loss, but also higher levels of insulation reliability than before are demanded.

As insulating materials of printed circuit boards for high-speed communication, for example, prepregs and laminates in which a resin composition containing a terminal-modified polyphenylene ether or the like is used are known. Specifically, prepregs obtained by impregnating a glass fabric with a low-dielectric thermosetting resin containing a terminal-modified polyphenylene ether or the like (hereinafter, generally referred to as "matrix resin") and then drying the glass fabric, and laminates obtained using these prepregs are known (PTLs 1 and 2).

PTL 3 discloses the production of a quartz glass fabric using glass yarns formed of 20 to 400 quartz glass filaments having an average filament diameter of 3 to 20 $\mu$m and a diameter standard deviation of 0.15 or less. Regarding the quartz glass fabric, PTL 3 reports that a further improved smoothness (smoothness of the glass fabric surface) can be obtained by reducing the twist number of the glass yarns constituting the glass fabric or by using untwisted yarns.

[CITATION LIST]

[PATENT LITERATURE]

[PTL 1] WO 2019/065940
[PTL 2] WO 2019/065941
[PTL 3] Japanese Unexamined Patent Publication (Kokai) No. 2016-11484

SUMMARY OF INVENTION

[TECHNICAL PROBLEM]

However, PTL 3 leaves room for improvement in terms of ensuring the outer appearance quality of the glass fabric. Particularly, when producing a glass fabric using glass yarns having a low twist number or untwisted glass yarns as in PTL 3, bundling of the glass yarns tends to be poor; therefore, the weft yarns of the resulting glass fabric are likely to have an excessively large skew amount. In this case, there is a problem that, since the glass fabric is likely to meander during its transport and this is likely to cause the formation of wrinkles on the glass fabric as a result, it is difficult to ensure the glass fabric with outer appearance quality.

In view of the above, an object of the present invention is to provide a glass fabric that has excellent smoothness and can ensure excellent outer appearance quality, even with the use of glass yarns (weft yarns) having a low twist number. Other objects of the present invention are to provide a prepreg obtained using the glass fabric, and to provide a printed circuit board, an integrated circuit, and an electronic device, which are obtained using the prepreg.

[SOLUTION TO PROBLEM]

Aspects of the present invention are as follows.

[1] A glass fabric, including glass yarns as warp yarns and weft yarns,

wherein the weft yarns have a twist number of 0.40 to 1.80 turns/25 mm or -1.80 to -0.40 turns/25 mm,
an absolute value difference in twist number between the warp yarns and the weft yarns is 0.01 to 0.70 turns/25 mm, and
the weft yarns have a skew amount of 35 mm or less.

[2] The glass fabric according to [1], wherein a silicon (Si) content in the glass yarns is 95.0 to 100% by mass in terms of silicon dioxide ($SiO_2$).

[3] The glass fabric according to [1] or [2], wherein the silicon (Si) content in the glass yarns is 99.0 to 100% by mass in terms of silicon dioxide ($SiO_2$).

[4] The glass fabric according to any one of [1] to [3], wherein the warp yarns have a twist number of 0.40 to 1.80 turns/25 mm or -1.80 to -0.40 turns/25 mm.

[5] The glass fabric according to any one of [1] to [4], wherein the glass yarns are treated with a surface treatment agent containing a silane coupling agent.

[6] The glass fabric according to [5], wherein the surface treatment agent contains a silane coupling agent represented by the following Formula (1):

$$X(R)_{3-n}SiY_n \qquad (1)$$

(wherein, X represents an organic functional group having at least one of an amino group or a radical-reactive unsaturated double bond group; each Y independently represents an alkoxy group; n represents an integer of 1 to 3; and each R independently represents a group selected from the group consisting of functional groups composed of hydrocarbon groups having 1 to 10 carbon atoms).

[7] The glass fabric according to [6], wherein X in Formula (1) is an organic functional group not forming a salt with an ionic compound.

[8] The glass fabric according to [6] or [7], wherein X in Formula (1) does not contain an amine or an ammonium cation.

[9] The glass fabric according to any one of [6] to [8], wherein X in Formula (1) is an organic functional group having one or more of at least one of a methacryloxy group or an acryloxy group.

[10] The glass fabric according to any one of [6] to [9], wherein R in Formula (1) is a group selected from the group consisting of a methyl group, an ethyl group, and a phenyl group.

[11] The glass fabric according to any one of [1] to [10], wherein the warp yarns and the weft yarns have a TEX of 0.5 to 40 g/1,000 m.

[12] The glass fabric according to any one of [1] to [11], wherein glass constituting the glass yarns has a bulk dielectric loss tangent in a range of 0.001 or less at 10 GHz.

[13] The glass fabric according to any one of [1] to [12], which is for a printed circuit board.

[14] A prepreg, including:

the glass fabric according to any one of [1] to [12];
a thermosetting resin; and
an inorganic filler.

[15] A printed circuit board, including the prepreg according to [14].

[16] An integrated circuit, including the printed circuit board according to [15].

[17] An electronic device, including the printed circuit board according to [15].

[ADVANTAGEOUS EFFECTS OF INVENTION]

An object of the present invention is to provide a glass fabric that has excellent smoothness and can ensure excellent outer appearance quality, even with the use of glass yarns having a low twist number.

According to the present invention, a prepreg obtained using the glass fabric, as well as a printed circuit board, an integrated circuit, and an electronic device, which are obtained using the prepreg, can be provided.

DESCRIPTION OF EMBODIMENTS

The present embodiment will now be described. The present invention is not limited to the present embodiment, and can be carried out with various changes within the scope of the gist of the present invention.

In the present specification, in those numerical ranges that are stated in a stepwise manner, the upper limit value or the lower limit value of one numerical range may be replaced with the upper limit value or the lower limit value of another corresponding numerical range, or may be replaced with a corresponding value indicated in the section of Examples. Further, in the present specification, the term "step" encompasses not only a discrete step but also a step that cannot be clearly distinguished from other steps, as long as the intended function of the step is achieved. Moreover, in the present specification, unless otherwise specified, various production, measurement, and the like are performed based on the methods described in the section of Examples.

[Embodiment 1]

<Glass fabric>

The present embodiment is a glass fabric including glass yarns as warp yarns and weft yarns, in which

the weft yarns have a twist number of 0.40 to 1.80 turns/25 mm or -1.80 to -0.40 turns/25 mm,
an absolute value difference in twist number between the warp yarns and the weft yarns is 0.01 to 0.70 turns/25 mm, and
the weft yarns have a skew amount of 25 mm or less.

According to this, a glass fabric that has excellent smoothness and can ensure excellent outer appearance quality can be provided even with the use of glass yarns having a low twist number.

The glass fabric may be produced in an elongated shape that has a longitudinal direction (MD direction in one aspect) and a transverse direction (TD direction in one aspect). In one aspect, the warp yarns are held in tension on a loom, and the weft yarns are woven in such a manner to pass over and under the warp yarns, whereby a glass fabric having a plain weave structure is formed. According to the present embodiment, glass yarns having a low twist number are used as the weft yarns woven into the warp yarns. The use of such weft yarns having a low twist number is advantageous from the standpoint of reducing the thickness unevenness (coefficient of variation of thickness) of the resulting glass fabric, i.e., from the standpoint of realizing a glass fabric having high smoothness. In this respect, the present inventors focused on actively ensuring an absolute value difference in twist number between the warp yarns and the weft yarns. According to the present embodiment, by actively ensuring an absolute value difference in twist number between the warp yarns and the weft yarns while using glass yarns (weft yarns) having a low twist number, the skew amount of the weft yarns can be controlled in a small range and, in this case, meandering of the glass fabric during its production, transport, and the like can be inhibited.

In the present embodiment, meandering of the glass fabric during its production, transport, and the like can be inhibited; therefore, the glass fabric is hardly wrinkled and, as a result, the outer appearance quality is likely to be ensured. In other words, the present embodiment provides a glass fabric that exhibits a low degree of deterioration in the outer appearance quality against various processes such as handling, storage, and transport, i.e., a glass fabric exhibiting a low degree of deterioration with time in the outer appearance quality.

Such glass fabric of the present embodiment is suitable as a constituent of a substrate in a printed circuit board. By using the glass fabric of the present embodiment, a highly reliable printed circuit board can be easily realized.

Twist Number of Glass Yarns

In the present embodiment, the weft yarns have a twist number of 0.40 to 1.80 turns/25 mm or - 1.80 to -0.40 turns/25 mm. When the twist number of the weft yarns is 0.40 turns/25 mm or more or -0.40 turns/25 mm or less, a sufficient twist number of the weft yarns can be ensured, so that not only the yarn breakage in the warping step but also the fluffing of the glass fabric can be inhibited. When the twist number of the weft yarns is 1.80 turns/25 mm or less or -1.80 turns/25 mm or more, the thickness unevenness of the resulting glass fabric can be reduced and, in this case, variation in the dimensional change in the warp and weft directions can be inhibited during the production of a printed circuit board. According to the present embodiment, a glass fabric that has excellent smoothness and can ensure excellent outer appearance quality can be provided even with the use of such weft yarns having a low twist number.

In the present embodiment, it is preferred that not only the weft yarns but also the warp yarns have a twist number of 0.40 to 1.80 turns/25 mm or -1.80 to -0.40 turns/25 mm. By this, the effects of the present embodiment are likely to be exerted.

The twist of a glass yarn is classified as the z-direction or the s-direction based on the direction in which the twist is performed. In the present embodiment, twist in the z-direction is defined as "positive", while twist in the s-direction is defined as "negative". For example, in the present specification, a "twist number of 1.00z" is denoted as a twist number of 1.00, and a "twist number of 1.00s" is denoted as a twist number of -1.00.

The twist number of the glass yarns can be adjusted, for example, in the step of twisting the glass yarns (twisting step). In one aspect, the twist number of the glass yarns can be easily increased by bundling glass filaments. An increase in the twist number of the glass yarns is likely to inhibit not only the fluffing caused by breakage of glass filaments but also the yarn breakage in the warping step of the glass fabric. On the other hand, twisting of the glass yarns is likely to hinder the widening of the glass yarns and cause the resulting glass fabric to have uneven thickness at twisted parts. Therefore, for the production of a glass fabric having excellent quality, it is advantageous to find an appropriate twist number and to use glass yarns adjusted to such a twist number.

The twist number of the weft yarns is preferably 0.40 to 1.50 turns/25 mm or -1.50 to -0.40 turns/25 mm, more preferably 0.50 to 1.30 turns/25 mm or -1.30 to -0.50 turns/25 mm, still more preferably 0.50 to 1.10 turns/25 mm or -1.10 to -0.50 turns/25 mm, yet still more preferably 0.60 to 1.00 turns/25 mm or -1.00 to -0.60 turns/25 mm, particularly preferably 0.60 to 0.90 turns/25 mm or -0.90 to -0.60 turns/25 mm. The twist number of the warp yarns is preferably 0.50 to 1.70 turns/25 mm or -1.70 to -0.50 turns/25 mm, more preferably 0.60 to 1.60 turns/25 mm or -1.60 to -0.60 turns/25 mm, still more preferably 0.60 to 1.40 turns/25 mm or -1.40 to -0.60 turns/25 mm, yet still more preferably 0.70 to 1.30 turns/25 mm or -1.30 to -0.70 turns/25 mm, particularly preferably 0.80 to 1.10 turns/25 mm or -1.10 to -0.80 turns/25 mm. From the standpoint of obtaining excellent productivity of the glass fabric, it is preferred that the twist number of the weft yarns be less than the twist number of the warp yarns.

Absolute Value Difference in Twist Number between Warp Yarns and Weft Yarns

In the present embodiment, an absolute value difference in twist number between the warp yarns and the weft yarns is 0.01 to 0.70 turns/25 mm. When the absolute value difference is 0.01 turns/25 mm or more, the thickness unevenness of the glass fabric can be reduced and, in this case, not only the smoothness of the glass fabric can be improved, but also the glass yarns can be easily opened during the production of the glass fabric. On the other hand, when the absolute value difference is 0.7 turns/25 mm or less, the fluffing of the resulting glass fabric is likely to be inhibited even with the use of weft yarns having a low twist number.

From the same standpoint, the absolute value difference in twist number between the warp yarns and the weft yarns is preferably 0.05 turns/25 mm or more, more preferably 0.08 turns/25 mm or more, still more preferably 0.10 turns/25 mm or more, yet still more preferably 0.13 turns/25 mm or more, further preferably 0.15 turns/25 mm or more, still further preferably 0.08 turns/25 mm or more, yet still further preferably 0.20 turns/25 mm or more, most preferably 0.30 turns/25 mm or more, but preferably 0.65 turns/25 mm or less, more preferably 0.60 turns/25 mm or less, still more preferably 0.0.55 turns/25 mm, yet still more preferably 0.13 to 0.52 turns/25 mm, further preferably 0.50 turns/25 mm or less, particularly preferably 0.45 turns/25 mm.

Constructing a glass fabric using weft yarns having a high twist number is one of the useful means for inhibiting the fluffing of the resulting glass fabric; however, in this case, the glass fabric cannot realize excellent smoothness. The present inventors focused on actively ensuring the absolute value difference in twist number between the warp yarns and the weft yarns of the glass fabric. The larger the absolute value difference in twist number between the warp yarns and the weft yarns of the glass fabric, the greater may be the skew amount of the weft yarns. When the skew amount of the weft yarns is large, the resulting glass fabric is likely to meander during its transport in the step of processing a prepreg using the glass fabric, as a result of which the yield of the prepreg is likely to decrease. In this respect, the present inventors discovered that a taper control of the yarn tension, in which the yarn tension is increased toward the respective ends based on the yarn tension at the center of yarns, can be performed in the yarn warping step.

In the present embodiment, by performing the taper control of the yarn tension in a preferred manner, the skew amount of the weft yarns can be easily reduced even when the absolute value difference in twist number between the warp yarns and the weft yarns is large. In this case, not only inhibition of the fluffing and reduction of the thickness unevenness are likely to be attained at the same time in the resulting glass fabric, but also inhibition of the meandering of the glass fabric during its transport and improvement in the yield of prepreg are likely to be realized.

The absolute value difference in twist number between the warp yarns and the weft yarns is derived by, for example, calculating the difference between the absolute value of the twist number of the warp yarns and the absolute value of the twist number of the weft yarns, and then determining the absolute value of the difference.

Skew Amount of Weft Yarns

In the present embodiment, the weft yarns have a skew amount of 35 mm or less. When the skew amount of the weft yarns is 35 mm or less, the meandering of the glass fabric during its transport can be inhibited. In this case, wrinkles are hardly generated on the glass fabric and, by extension, the resulting prepreg. From the same standpoint, the skew amount of the weft yarns is preferably 30 mm or less, or 25 mm or less, more preferably 20 mm or less, still more preferably 18 mm or less, particularly preferably 16 mm or less, or 14 mm or less. The skew amount of the weft yarns may be 0 mm or more.

As described above, by performing the taper control of the yarn tension in a preferred manner, the skew amount of the weft yarns can be easily reduced even when the absolute value difference in twist number between the warp yarns and the weft yarns is large. In other words, it is possible to control the skew amount of the weft yarns as appropriate based on, for example, the twist number of the warp yarns and that of the weft yarns, as well as the conditions of the taper control of the yarn tension.

Average Filament Diameter of Glass Yarns

The glass filaments have an average filament diameter of preferably 2.5 to 9.0 $\mu$m, more preferably 2.5 to 7.5 $\mu$m,

still more preferably 3.5 to 7.0 $\mu$m, yet still more preferably 3.5 to 6.0 $\mu$m, particularly preferably 3.5 to 5.0 $\mu$m.

TEX of Glass Yarns

The glass yarns have a TEX of preferably 0.5 to 40 g/1,000 m, more preferably 0.8 to 35 g/1,000 m, still more preferably 1.0 to 30 g/1,000 m, yet still more preferably 1.5 to 25 g/1,000 m, particularly preferably 2.0 to 20 g/1,000 m. When the TEX is 0.5 g/1,000 m or more, breakage of the glass yarns is likely to be inhibited in the glass fabric production process, and the resulting glass fabric is likely to be prevented from being severed. When the TEX is 40 g/1,000 m or less, a situation where the glass fabric is excessively thick is likely to be avoided, and the effects exerted by ensuring the absolute value difference in twist number between the warp yarns and the weft yarns (e.g., the effect of reducing the thickness unevenness of the glass fabric) are likely to be obtained.

Thread count

The thread count of the warp yarns and the weft yarns is preferably 10 to 120 yarns/25 mm, more preferably 40 to 100 yarns/25 mm, still more preferably 40 to 100 yarns/25 mm.

Thickness of Glass Fabric

The glass fabric has a thickness of preferably 5 to 150 $\mu$m, more preferably 10 to 120 $\mu$m, still more preferably 15 to 100 $\mu$m, yet still more preferably 20 to 90 $\mu$m, particularly preferably 30 to 70 $\mu$m. When the thickness of the glass fabric is in this range, the effects exerted by ensuring the absolute value difference in twist number between the warp yarns and the weft yarns (e.g., the effect of reducing the thickness unevenness of the glass fabric) are likely to be obtained.

Coefficient of Variation of Thickness of Glass Fabric

The coefficient of variation of the thickness of the glass fabric is preferably 10% or less, more preferably 8% or less, still more preferably 6% or less, yet still more preferably 5% or less, particularly preferably 3% or less. In one aspect, a "glass fabric having excellent smoothness" means a "glass fabric having a coefficient of variation of the thickness of 10% or less". By using a glass fabric having a coefficient of variation of the thickness in the above-described range, a prepreg having excellent dimensional stability and, by extension, a printed circuit board having excellent dimensional stability can be easily realized.

Weave Structure

Examples of the weave structure of the glass fabric include those of plain weave, basket weave, satin weave, and twill weave. Thereamong, a plain weave structure is preferred as the weave structure of the glass fabric.

Type of Glass

Examples of the type of glass constituting the glass yarns include a glass called E-glass (alkalifree glass). Examples of the type of glass constituting the glass yarns also include L-glass, NE-glass, D-glass, L2-glass, T-glass, silica glass, and quartz glass. From the standpoint of realizing excellent dielectric characteristics, preferred examples of the type of glass constituting the glass yarns include L-glass, L2-glass, silica glass, and quartz glass, among which silica glass and quartz glass are more preferred. Further, from the standpoint of improving the dimensional stability of the resulting prepreg, preferred examples of the type of glass constituting the glass yarns include S-glass, T-glass, silica glass, and quartz glass, among which silica glass and quartz glass are more preferred as the type of glass constituting the glass yarns.

In a glass fabric formed of silica glass (silica glass fabric) or a glass fabric formed of quartz glass (quartz glass fabric), the Si content of the glass yarns is, in terms of $SiO_2$, preferably 95.0 to 100% by mass, more preferably 99.0 to 100% by mass, still more preferably 99.5 to 100% by mass, yet still more preferably 99.7 to 100% by mass, particularly preferably 99.9 to 100% by mass. Glass yarns having a Si content of 95.0% by mass or more are likely to cause thickness unevenness in the glass fabric at twisted parts of the glass yarns because the hardness of glass itself is high. Therefore, when glass having a Si content of 95.0% by mass or more is used, the benefits of the effects exerted by ensuring the absolute value difference in twist number between the warp yarns and the weft yarns (e.g., the effect of reducing the thickness unevenness of the glass fabric) are likely to be obtained.

Bulk Dielectric Loss Tangent of Glass

In the glass fabric of the present embodiment, the bulk dielectric loss tangent at 10 GHz of the glass raw material constituting the glass fabric is measured by a method using a split cylinder resonator (a technique employing a resonance method), specifically the method described below in the section of Examples. It is noted here that the glass raw material may be, for example, glass yarns, glass filaments, and glass seeds.

The bulk dielectric loss tangent at 10 GHz is preferably 0.001 or less, more preferably 0.0008 or less, still more preferably 0.0006 or less, yet still more preferably 0.0004 or less, particularly preferably 0.0003 or less. By this, the effects of the present disclosure are more likely to be exerted.

Silane Coupling Agent

The glass yarns (including the glass filaments) that constitute the glass fabric are preferably surface-treated with a surface treatment agent. In one aspect, the surface treatment agent of the glass yarns contains a silane coupling agent. The silane coupling agent is preferably, for example, one represented by the following Formula (1):

$$X(R)_{3-n}SiY_n \qquad (1)$$

{wherein, X represents an organic functional group having at least one of an amino group or a radical-reactive unsaturated double bond group such as a radical-reactive carbon-carbon double bond; each Y independently represents an alkoxy group; n represents an integer of 1 to 3; and R represents a group selected from the group consisting of hydrocarbon groups having 1 to 10 carbon atoms}.

In Formula (1), R is preferably a group selected from the group consisting of a methyl group, an ethyl group, and a phenyl group.

In the present embodiment, from the standpoint of the ease of obtaining a glass fabric having excellent dielectric characteristics, X in Formula (1) is preferably an organic functional group not forming a salt with an ionic compound. From the standpoint of obtaining excellent reactivity with a matrix resin, X in Formula (1) is more preferably an organic functional group having one or more methacryloxy groups or acryloxy groups. From the standpoint of obtaining good reactivity with a radical-reactive matrix resin, X in Formula (1) is preferably an amine such as a primary amine, a secondary amine, or a tertiary amine, and preferably does not contain an ammonium cation such as a quaternary ammonium cation.

Regarding Y in the above-described Formula (1), from the standpoint of the ease of achieving stabilization of the glass fabric, the alkoxy group is preferably an alkoxy group having 1 to 5 carbon atoms (1, 2, 3, 4, or 5 carbon atoms).

As the surface treatment agent, a silane coupling agent represented by Formula (1) may be used singly, or a mixture of two or more kinds of silane coupling agents that are different in X of Formula (1) may be used. Examples of the silane coupling agent represented by Formula (1) include: simple substances such as vinyltrimethoxysilane, 3-methacryloxypropyltrimethoxysilane, acryloxypropyltrimethoxysilane, 3-acryloxypropyltrimethoxysilane, and 5-hexenyltrimethoxysilane; and mixtures of these simple substances.

The silane coupling agent has a molecular weight of preferably 100 to 600, more preferably 150 to 500, still more preferably 200 to 450. Particularly, it is preferred to use two or more kinds of silane coupling agents that are different in molecular weight. By treating the surfaces of the glass yarns with two or more kinds of silane coupling agents that are different in molecular weight, the density of the treatment agent on the glass surface is likely to be increased and, in this case, the reactivity with a matrix resin is likely to be further improved.

The silane coupling agent is preferably nonionic since such a silane coupling agent hardly hinders the reactivity with a resin. Among nonionic silane coupling agents, a silane coupling agent having at least one group selected from the group consisting of a vinyl group, a methacryloxy group, and an acryloxy group is preferred, and a silane coupling agent having at least one methacryloxy group or acryloxy group is particularly preferred. By not hindering reactivity with a resin, the heat resistance and the reliability of a printed circuit board can be improved.

In one aspect, X in Formula (1) is an organic functional group having at least one of the above-described unsaturated double bond group or an amino group. Accordingly, the scope of Formula (1) includes not only an aspect in which X has both the unsaturated double bond group and the amino group, but also an aspect in which X has the unsaturated double bond group but not the amino group, as well as an aspect in which X has the amino group but not the unsaturated double bond group. However, X in Formula (1) is preferably the unsaturated double bond group, and preferably does not contain an amino group.

<Glass fabric Production Method>

Another aspect of the present embodiment is a production method for producing the above-described glass fabric. This production method is a glass fabric production method that includes, for example, the following steps of:

warping yarns to obtain warp section beams (warping step); and

weaving a glass fabric using the section beams (weaving step),

in which the warping step includes performing a taper control of increasing the yarn tension toward the respective ends based on the yarn tension at the center of the yarns.

The glass fabric production method may include, after the warping step, the step of combining the thus obtained section beams to prepare a single loom beam (beaming step). This enables the weaving of a glass fabric using the loom beam obtained in the beaming step and, in this case, a glass fabric excellent in various properties can be easily produced.

The glass fabric production method may also include the step of heat-deoiling the thus woven glass fabric (heat-deoiling step). By this, the dielectric loss tangent of the glass fabric can be easily reduced in a preferred manner.

Further, the glass fabric production method may include:

the step of applying a treatment solution containing a silane coupling agent to the glass fabric (coating step); and

the step of drying the treatment solution and fixing the silane coupling agent onto the surfaces of glass filaments (drying step).

By this, the glass fabric can be easily surface-treated in a preferred manner.

Moreover, the glass fabric production method may include the step of washing off the silane coupling agent (in one aspect, the silane coupling agent not forming a chemical bond with the surface of a glass filament) and performing a glass filament opening treatment (opening filament step). By this, the glass fabric can be easily opened in a preferred manner.

The coating step, the drying step, and the opening filament step may be performed on glass yarns before the weaving step of weaving the glass yarns to obtain a glass fabric, or may be performed on the glass fabric after the weaving step. The order of the heat-deoiling step, the coating step, the drying step, and the opening filament step may be changed as appropriate, and these steps can be repeated. When the washing step is performed after the weaving step, the washing step may be performed using a high-pressure water spray or the like and double as the opening filament step. It is noted here that the composition of the glass fabric does not usually change before and after the opening.

Warping Step

In the warping step, the warp yarns are warped to obtain warp beams.

The warping step may include, for example:

the step of aligning plural warp yarns at desired thread count and width; and

the step of performing a sizing treatment on the warp yarns.

Particularly, in the sizing treatment, for the purposes of inhibiting fluffing on the glass yarns and preventing water absorption, a sizing agent containing starch and/or polyvinyl alcohol (PVA) as main components can be adhered to the surfaces of the glass yarns.

In the warping step, a taper control of increasing the yarn tension toward the respective ends based on the yarn tension at the center of yarns is performed. Even when glass yarns having a low twist number are used as the weft yarns, it is advantageous to perform such taper control for reducing the skew amount of the weft yarns. In the taper control, for example, when 800 warp yarns are warped, the yarn tension of the 400th and the 401st yarns in the center is set at 5 g, and the yarn tension of the 1st and the 800th yarns on the respective ends is set at 8 g. As for the yarn tension of the 2nd to the 399th yarns and the 402nd to the 799th yarns, the yarn tension of each yarn is controlled such that the yarn tension continuously increases toward the respective ends. The yarn tension to be increased toward the respective ends (taper control amount) is calculated by the following equation:

$$\text{Taper control amount: } (8 \text{ g} - 5 \text{ g}) \div 399 \text{ yarns} \approx 0.0075 \text{ g/yarn}$$

In the present example, the 341st yarn and the 460th yarn have a yarn tension of $5 \text{ g} + 0.0075 \text{ g} \times 59 \approx 5.4 \text{ g}$. It is noted here that, for convenience of description, the value is rounded off to one decimal place.

The number of warp yarns that are selected to be in the center is 1 when the total number of warp yarns is an odd number, or 2 when the total number of warp yarns is an even number. As in the above-described example, when the total number of warp yarns is an even number, the same yarn tension is set for the two warp yarns that are selected to be in the center.

Beaming Step

In the beaming step, the section beams obtained in the above-described warping step are combined to prepare a single loom beam (warp yarn beam). According to this beaming step, a loom beam that can be set on a loom can be easily prepared from the section beams obtained in the warping step. The number of warp yarns in the loom beam and the number of bundles of the section beams to be beamed are adjusted as appropriate in accordance with the thread count and the width of the warp yarns of the resulting glass fabric. In one aspect, the number of warp yarns in each section beam is about 800, and the number of bundles of the section beams to be beamed is about 4.

In one aspect, when a single loom beam is prepared by combining four section beams obtained in the warping step, the warp yarns are provided sequentially from each section beam. For example, when four bundles of section beams (A) to (D) are used and the 1st warp yarn of a loom beam (A) is referred to as "(A)-1", the warp yarns are provided sequentially from each section beam in the order of (A)-1, (B)-1, (C)-1, (D)-1, (A)-2, (B)-2, (C)-2, (D)-2, (A)-3, and so on. By this, the effect of the taper control performed in the warping step is likely to be obtained. In other words, the yarn tension in the glass fabric is likely to be controlled to be higher on both ends than in the center part in a preferred manner and, in this case, even when weft yarns having a low twist number are used, the skew amount of the weft yarns is likely to be controlled to be small.

Weaving Step

**In the weaving** step, a glass fabric is woven using a beam, preferably the loom beam prepared in the beaming step. **In** this step, glass yarns having different twist numbers are used as each of the warp yarns and the weft yarns so as to ensure an absolute value difference in twist number between the warp yarns and the weft yarns. From the standpoint of obtaining excellent productivity of the glass fabric, it is preferred that the twist number of the weft yarns be less than the twist number of the warp yarns.

Heat-Deoiling Step

**In** the heat-deoiling step, the thus woven glass fabric is heat-deoiled. When a sizing treatment is performed on the warp yarns in the warping step, the sizing agent applied to the warp yarns is suitably removed in this heat-deoiling step. It is noted here, however, that the heat-deoiling step may be performed regardless of the presence or absence of the sizing treatment.

As a means for the heat-deoiling, any known heating method, heating medium, heating mechanism, heating device, and heating component can be used. Specific examples of a heat-deoiling method include: a method of heat-deoiling the glass fabric at a temperature of 600 to 1,600°C; and a method of heating the glass fabric in vacuum or in a gas having a dew point of 15°C or lower under conditions where the maximum heating temperature is 100°C to 600°C and the heating amount, which is represented by [heating temperature (°C) of 100°C or higher × heating time (h)], is 450 (°C·h) or more.

In the case of performing the heat-deoiling treatment in a closed system, from the standpoint of achieving suitable heating by the heating means, it is preferred to place the glass fabric in a heating furnace and, from the standpoint of storage space and space saving, it is preferred to heat the glass fabric while storing it in the state of a roll. Further, from the standpoint of increasing the efficiency of the removal of organic matter as well as the standpoint of shortening the time required for the removal of organic matter, it is also preferred to heat the glass fabric while transporting it in a heating furnace.

In the case of performing the heat-deoiling treatment in a closed system, from the standpoint of the area to be heated, it is preferred to heat the glass fabric while transporting it. The glass fabric can be transported by, for example, a combination of a mechanism for unwinding the rolled glass fabric (unwinding mechanism) and a mechanism for winding up the unwound glass fabric (winding mechanism).

The heat-deoiling step preferably includes the step of heat-treating the glass fabric in a range of 600 to 1,600°C (heat treatment step). In the heat treatment step, a greige fabric of the glass fabric, in which the glass yarns have a softening point of 900°C or higher, is heat-deoiled in a temperature range of 600 to 1,600°C, whereby the dielectric loss tangent of the glass fabric can be reduced while reducing the damage to the glass fabric. When the heat-deoiling temperature is 600°C or higher, the dielectric loss tangent of the resulting glass fabric is likely to be effectively reduced. When the heat-deoiling temperature is 1,600°C or lower, the devitrification phenomenon of glass is likely to be inhibited and, therefore, a reduction in the strength of the glass fabric is likely to be prevented. From the same standpoint, the heat-deoiling temperature is more preferably 700 to 1,500°C, still more preferably 800 to 1,400°C, yet still more preferably 900 to 1,300°C, particularly preferably 1,000 to 1,200°C.

In the heat-deoiling step, the heating time is preferably 10 minutes or shorter, more preferably 5 minutes or shorter, still more preferably 2 minutes or shorter, particularly preferably 90 seconds or shorter. When the heating time is 10 minutes or shorter, the damage to the glass fabric is small; therefore, for example, a situation where the glass fabric is partially perforated during processing and a situation where the glass fabric is severed are likely to be avoided. The heating time may be, for example, 1 second or longer, 5 seconds or longer, 10 seconds or longer, or 15 seconds or longer.

(Heating Furnace)

In the heat-deoiling step, the heating furnace used as a heating means is not limited as long as it can achieve the above-described conditions in the heat-deoiling, and examples thereof include electric heaters and burners. A plurality of such heating furnaces may be used in combination. As the heating furnace, a gas-type single radiant tube burner or an electric heater is preferably used.

From the standpoint of efficiently removing organic matter adhering to the glass fabric surface, a continuous system in which the glass fabric can be heated while being passed through the heating furnace continuously is more preferred than a batch system in which a glass fiber fabric is wound on a core tube and the glass fabric is heated at a prescribed atmosphere temperature. Further, a system in which the glass fabric can be continuously washed with washing water having a low metal ion content, such as reverse osmosis (RO) water or ion-exchanged water, is also preferred.

(Contact Member for Heating Glass fabric)

As a method of heating the glass fabric, the above-described heating furnace may be used; however, from the standpoint of attaining a low running cost, the glass fabric may be heated by being brought into contact with a member (contact member) heated to a prescribed temperature.

From the standpoint of the ease of transporting the glass fabric, the contact member is preferably a roller. This roller is preferably one heated by an induction heating system, which can be used in high-temperature ranges and has a relatively small temperature variation in the width direction. When the glass is heated with such a contact member, the temperature of the contact member and the surface temperature of the glass fabric are expected to be substantially the same.

For continuous heating of the glass fabric, in order to remove foreign matter (e.g., carbide) adhering to the roller, it is preferred to employ a system provided with a mechanism for removing the foreign matter, such as a blade.

(Means for Applying High-Temperature Steam to Glass fabric)

As a method of heating the glass fabric, high-temperature steam may be applied to the glass fabric. The steam applied to the glass fabric may contain, for example, a volatile solvent and water vapor, and may also contain gases and the like other than water vapor. Particularly, from the standpoint of reducing the toxicity to the human body and the ease of accelerating the decomposition of the sizing agent used on glass fibers, the steam applied to the glass fabric is preferably water vapor. Regarding the temperature of the high-temperature steam, in order to bring the surface temperature of the glass fabric to a temperature higher than 650°C, if necessary, a method of supplying the high-temperature steam and heated air at an arbitrary ratio may be employed. The temperature of the high-temperature steam is 400°C or higher, preferably 450°C or higher, more preferably 550°C or higher, still more preferably 600°C or higher, particularly preferably 650°C or higher. As a steam application means, spraying, shower dispersion, a jet nozzle, and the like may be used. A gas discharged from the heating furnace may be reused as the high-temperature steam.

When the amount of sodium ions adhering to the surface of the glass fabric exceeds a prescribed amount, heat-deoiling of the glass fabric at 700°C or higher is likely to cause a marked decrease in the tensile strength of the glass fabric due to the devitrification phenomenon of quartz glass. In order to inhibit this devitrification phenomenon, the glass fabric may be washed with water having a sodium ion content of 20 ppm or less before the heat-deoiling. By this, the amount of sodium ions on the glass surface is likely to be reduced and, in this case, even when the heat-deoiling is performed at 700°C or higher, the devitrification phenomenon of quartz glass is likely to be inhibited. By maintaining the strength of the glass fabric after the heat-deoiling, for example, wrinkles and/or scratches in the step of treating the glass fabric with a surface treatment agent are likely to be inhibited.

From the standpoint of suitably obtaining the effects of the present embodiment, the sodium ion content in the water for washing is preferably 18 ppm or less, more preferably 15 ppm or less, still more preferably 12 ppm or less, yet still more preferably 10 ppm or less, particularly preferably 7 ppm or less. If the sodium ion content exceeds 20 ppm, it is difficult to inhibit the devitrification phenomenon of quartz glass when the heat-deoiling is performed at 700°C or higher and, in this case, a decrease in the tensile strength of the glass fabric is likely to occur. The sodium ion content may be 0 ppm, and may exceed 0 ppm.

Examples of a means for washing the glass fabric include a method using ultrasonic waves (specifically, for example, a method using an ultrasonic vibrator), a method using a spray (specifically, for example, a method using a high-pressure spray), and a method of spraying water vapor. From the standpoint of the ease of inexpensively performing the washing, a method of immersing the glass fabric in a water tank storing washing water (water having a sodium ion content of 20 ppm or less), subsequently removing excess washing water using a squeeze roller or the like, and then drying the glass fabric is preferred. In this case, the immersion time may be, for example, 2 seconds or longer, 5 seconds or longer, 10 seconds or longer, or 15 seconds or more, but 120 seconds or shorter, 90 seconds or shorter, 60 seconds or shorter, or 45 seconds or shorter.

The water having a sodium ion content of 20 ppm or less may be produced by, for example, filtration using an RO membrane, or deionization using an ion exchange resin. The "water having a sodium ion content of 20 ppm or less" may contain other liquid components (e.g., a liquid other than water) within a range that does not impair the effects of the present embodiment.

Coating Step

The coating step is the step of applying a treatment solution containing a silane coupling agent to the glass fabric. Examples of a method of applying the treatment solution to the glass fabric include:

(a) a method of immersing and/or passing the glass fabric in the treatment solution stored in a bath (hereinafter, referred to as "immersion method"); and
(b) a method of directly applying the treatment solution to the glass fabric using a roll coater, a die coater, a gravure coater, or the like. When the immersion method is employed, the immersion time of the glass fabric in the treatment solution is preferably set to be 0.5 seconds to 1 minute.

In the treatment solution used in the coating step, for example, the concentration of the silane coupling agent is 0.01 to 1.5% by weight.

Drying Step

In the drying step, the treatment solution is dried, and the silane coupling agent is fixed onto the surfaces of glass filaments. Examples of a method for drying the treatment solution, preferably for heat-drying the treatment solution, include hot-air drying, and drying with electromagnetic waves or the like.

The drying temperature is preferably 80°C or higher, more preferably 90°C or higher, such that the reaction between the silane coupling agent and glass sufficiently proceeds. From the standpoint of inhibiting the deterioration of an organic functional group contained in the silane coupling agent, the drying temperature is preferably 300°C or lower, more preferably 180°C or lower.

Opening filament step

In the opening filament step, the silane coupling agent (in one aspect, the silane coupling agent not forming a chemical bond with the surface of a glass filament) is washed off, and a glass filament opening treatment is performed. As an opening method, for example, a method of opening the glass fabric with spray water (high-pressure water opening), a vibro-washer, ultrasonic water, a mangle, or the like may be employed. By reducing the tension applied to the glass fabric during this opening process, not only the width of the glass yarns is likely to be increased, but also the silane coupling agent not chemically bound with the glass surface is likely to be removed to a certain extent. In order to inhibit a reduction in the tensile strength of the glass fabric caused by the opening processing, it is preferred to take measures such as reducing the friction of the contact member at the time of weaving the glass yarns, and increasing the adhesion amount of the sizing agent.

<Prepreg>

Yet another aspect of the present embodiment is a prepreg.

This prepreg includes at least the above-described glass fabric, and a matrix resin with which the glass fabric is impregnated.

As the matrix resin, either a thermosetting resin or a thermoplastic resin can be used.

Examples of the thermosetting resin include:

a) epoxy resins obtained by reacting a compound having an epoxy group and a compound having at least one of an amino group, a phenol group, an acid anhydride group, a hydrazide group, an isocyanate group, a cyanate group, a hydroxy group, or the like that reacts with the epoxy group, in the absence of a catalyst or with an addition of a catalyst having a reaction catalytic ability such as an imidazole compound, a tertiary amine compound, a urea compound, or a phosphorus compound, and curing the resultant;

b) radically polymerizable curable resins obtained by curing a compound having at least one of an allyl group, a methacryl group, or an acrylic group with the use of a thermal decomposition catalyst or a photodecomposition catalyst as a reaction initiator;

c) maleimide triazine resins obtained by reacting and curing a cyanate group-containing compound and a maleimide group-containing compound;

d) thermosetting polyimide resins obtained by reacting and curing a maleimide compound and an amine compound; and

e) benzoxazine resins obtained by cross-linking and curing a benzoxazine ring-containing compound by heat polymerization.

Examples of the thermoplastic resin include polyphenylene ether, modified polyphenylene ether, polyphenylene sulfide, polysulfone, polyether sulfone, polyarylate, aromatic polyamide, polyether ether ketone, thermoplastic polyimide, insoluble polyimide, polyamideimide, and fluororesins.

In the present embodiment, a thermosetting resin and a thermoplastic resin may be used in combination. If desired, the prepreg may contain an inorganic filler. The inorganic filler is preferably used in combination with a thermosetting resin. Examples of the inorganic filler include aluminum oxide, zirconium oxide, calcium carbonate, alumina, mica, aluminum carbonate, magnesium silicate, aluminum silicate, silica, talc, short glass fibers, aluminum borate, and silicon carbide.

<Printed circuit board>

Yet another aspect of the present embodiment is a printed circuit board.

This printed circuit board includes the above-described prepreg. By this, a printed circuit board having excellent insulation reliability can be provided.

<Integrated Circuit and Electronic Device>

Other aspects of the present embodiment are an integrated circuit and an electronic device.

The integrated circuit and the electronic device each include the above-described printed circuit board. By this, an integrated circuit and an electronic device that are excellent in various properties can be provided.

EXAMPLES

The present embodiment will now be described in more detail by way of Examples and Comparative Examples. The present embodiment is not limited to the below-described Examples. The parameter values described herein were measured by the respective methods described in the present section of Examples.

[Measurement and Evaluation]

<Thickness of Glass fabric and Standard Deviation of Thickness>

In accordance with 7.10 of JIS R3420, using a micrometer, a gently rotating spindle was brought into light parallel contact with the measurement surface, and the scale was read when the ratchet sounded three times. The thus read value was taken as the thickness of each glass fabric. JIS R3420 prescribes general test methods for glass long fibers and products such as glass fabrics using glass long fibers.

The thickness of each glass fabric was measured 50 times at different measurement positions and, from the average and the standard deviation of the thus measured values, the coefficient of variation (%) of the thickness of the glass fabric was calculated using the following equation: Coefficient of variation (%) = {(Standard deviation of thickness)/(Average value of thickness)}

$\times$ 100.

<Skew Amount of Weft Yarns>

Measurement was performed in accordance with JIS L1096 to determine the skew amount (mm) of weft yarns. Specifically, an average value obtained by the following operations (1) to (3) was taken as "skew amount of weft yarns":

(1) a single weft yarn in a glass fabric stretched on a pair of rolls was visually observed;

(2) using the TD tangent between the rolls and the fabric as a reference line, the amount of displacement from the reference line was measured; and

(3) the difference between the maximum value and the minimum value of the thus measured amount of displacement was calculated, and these operations were performed five times to calculate the average value of the difference.

<TEX of Glass Yarns>

Measurement was performed in accordance with JIS R3911 to determine the TEX (g/1,000 m) of glass yarns.

It is noted here that the values of "TEX" in the table below are values measured for the glass yarns used as a raw material of the respective glass fabrics, and these values are also taken as values measured for the glass yarns (warp yarns and weft yarns) that were extracted from the respective glass fabrics obtained using the glass yarns.

<Twist Number of Glass Yarns and Absolute Value Difference Thereof>

Measurement was performed in accordance with JIS R3420 to determine the twist number (turns/25 mm) of glass yarns. In the measurement of the twist number, the glass yarns were pulled out from each glass fabric and the measurement was performed for these glass yarns such that the twist number of the glass yarns in the glass fabric could be accurately measured. With regard to the thus obtained values, the twist in the z-direction was taken as positive, while the twist in the s-direction was taken as negative. For example, a twist of 1.00z (twist of 1.00 (turns/25 mm) in the z-direction) was taken as +1.00, and a twist of 1.00s (twist of 1.00 (turns/25 mm) in the s-direction) was taken as -1.00. The absolute value difference in twist number (turns/25 mm) between the warp yarns and the weft yarns was calculated using the following equation:

Absolute value difference in twist number = |Twist number of warp yarns - Twist number of weft yarns|

<Bulk Dielectric Loss Tangent of Glass>

A 300 $\mu$m-thick glass plate of the same type and composition as each glass fabric was prepared. Then, using the thickness determined from the thickness measurement of the glass plate, the bulk dielectric loss tangent of glass at 10 GHz was determined. Specifically, in accordance with IEC 62562, a glass plate that was sampled at a size required for the measurement using a split cylinder resonator was stored and humidity-conditioned in a constant temperature and humidity oven at 23°C and 50%RH for 8 hours. Subsequently, the dielectric characteristics at 10 GHz were measured using a split cylinder resonator (manufactured by EM Labs, Inc.) and an impedance analyzer (manufactured by Agilent Technologies, Inc.). The measurement was performed five times for each sample, and an average value thereof was calculated. It is noted here that IEC 62562 mainly prescribes a method for measuring the dielectric characteristics in the microwave band of fine ceramic materials used in microwave circuits.

<Fluff Quality>

On a roll-to-roll inspection table, while applying a tension of 100 N/1,000 mm and irradiating a halogen lamp to each of the glass fabrics obtained in Examples and Comparative Examples, the number of fluffs, particularly the number of fluffs with projections of 1 mm or larger, was visually determined. The number of fluffs per m$^2$ was taken as the fluff frequency and, based on this value, the fluff quality was evaluated in accordance with the following criteria.

(Measurement Criteria)

Fluff quality A: The fluff frequency is 15 fluffs/m$^2$ or less.
Fluff quality B: The fluff frequency is 16 to 30 fluffs/m$^2$.
Fluff quality C: The fluff frequency is 31 fluffs/m$^2$ or more.

In the table below, examining the relationship between "Twist number" of "Weft yarns" and "Fluff quality", good fluff quality was observed in Examples in which the twist number of the weft yarns was somewhat large; however, the fluff quality was evaluated as C in Comparative Example 3 in which the twist number of the weft yarns was the smallest. With regard to "Twist number" of "Weft yarns" and "Fluff quality", it is inferred that a glass fabric having a smaller twist number of weft yarns tends to have poorer fluff quality. According to the glass fabrics of Examples in which good fluff quality was observed, printed circuit boards obtained using these glass fabrics are expected to exhibit an improved reliability (e.g., inhibition of insulation failure).

[Examples and Comparative Examples]

<Example 1>

Glass yarns having an $SiO_2$ composition amount of more than 99.9% by mass (bulk dielectric loss tangent of glass at 10 GHz = 0.0002) were used as warp yarns and weft yarns. **In** the yarn warping step, 857 glass yarns having a TEX of 5.0 and a twist number of +1.00 (filament diameter = 5.0 μm, number of filaments = 100) were arranged and processed into a section beam. The tension during the warping was set to 8.0 g/yarn for the 1st and 857th yarns, and 5.0 g/yarn for the 429th yarn. For the 2nd to 428th yarns and the 430th to 856th yarns, a taper control of increasing the yarn tension by an increment of 0.007 g toward the respective ends based on the 429th yarn (the yarn positioned in the center of the 857 yarns) was performed. The yarn tension was controlled in values rounded off to one decimal place. A total of four section beams were prepared under the above-described conditions.
The thus obtained section beams were arranged in order, and a loom beam having a total of 3,428 warp yarns was prepared. Using the thus obtained loom beam and an air-jet loom, a 1,310 mm-wide glass fabric having a thread count of 65.0 warp yarns/25 mm and 66.9 weft yarns/25 mm was woven. In this process, glass yarns having a TEX of 5.0 were used as the weft yarns, and the twist number of the glass yarns and the weaving conditions were adjusted such that the weft yarns of the resulting glass fabric had a twist number of +0.65. The thus obtained greige glass fabric was washed with ion-exchanged water, subsequently dried, and then heat-deoiled at 800°C over a period of 50 seconds.
Thereafter, the thus heat-deoiled glass fabric was immersed in a treatment solution. This treatment solution was prepared by 0.2% of 3-methacryloxypropyltrimethoxysilane as a silane coupling agent (Z6030, manufactured by Dow Toray Co., Ltd.) in pure water adjusted to pH = 3 with acetic acid. The glass fabric from which the treatment solution was squeezed was heat-dried at 110°C for 1 minute. The thus dried glass fabric was irradiated with ultrasonic waves at a frequency of 25 kHz and an output of 0.50 W/cm$^2$ in water to perform an opening filament treatment, after which the glass fabric was dried at 110°C for 1 minute, whereby a surface-treated glass fabric was obtained.
In the table below, regarding the yarn warping step:

the yarn tension (g/yarn) at the center (the 429th yarn positioned in the center of the 857 yarns) is denoted as "center";
the yarn tension (g/yarn) at the respective ends (the 1st and 857th yarns positioned on the respective ends of the 857 yarns) is denoted as "both ends"; and
the amount of increase in the yarn tension (g/yarn) in the taper control of increasing the yarn tension from the center toward both ends is denoted as "taper amount".

<Examples 2, 3, 4, 9, and 10>

Glass fabrics were obtained in the same manner as in Example 1, except that the values and control were changed as shown in the table below.

<Example 5>

Glass yarns having an $SiO_2$ composition amount of more than 99.9% by mass (bulk dielectric loss tangent of glass at 10 GHz = 0.0002) were used as warp yarns and weft yarns. In the yarn warping step, 689 glass yarns having a TEX of 9.8 and a twist number of +1.00 (filament diameter = 5.0 μm, number of filaments = 200) were arranged and processed into a section beam. The tension during the warping was set to 8.0 g/yarn for the 1st and 689th yarns, and 5.0 g/yarn for the 345th yarn. For the 2nd to 344th yarns and the 346th to 688th yarns, a taper control of increasing the yarn tension by an increment of 0.009 g toward the respective ends based on the 345th yarn (the yarn positioned in the center of the 689 yarns) was performed. The yarn tension was controlled in values rounded off to one decimal place. A total of four section beams were prepared under the above-described conditions.
The thus obtained section beams were arranged in order, and a loom beam having a total of 2,756 warp yarns was prepared. Using the thus obtained loom beam and an air-jet loom, a 1,310 mm-wide glass fabric having a thread count of 52.6 warp yarns/25 mm and 52.6 weft yarns/25 mm was woven. In this process, glass yarns having a TEX of 9.8 were used as the weft yarns, and the twist number of the glass yarns and the weaving conditions were adjusted such that the weft yarns of the resulting glass fabric had a twist number of +0.50. The thus obtained greige glass fabric was washed with ion-exchanged water, subsequently dried, and then heat-deoiled at 800°C over a period of 50 seconds.
Thereafter, a glass fabric (surface-treated glass fabric) was obtained in the same manner as in Example 1.

<Example 6> to <Example 8>

Glass fabrics were obtained in the same manner as in Example 5, except that the values and control were changed as shown in the table below.

<Comparative Example 1> to <Comparative Example 3>

Glass fabrics were obtained in the same manner as in Example 1, except that the values and control were changed as shown in the table below.

<Prepreg Production Method>

A varnish was prepared by mixing 45 parts by mass of polyphenylene ether (NORYL SA9000, manufactured by SABIC Corporation), 10 parts by mass of triallyl isocyanurate, 45 parts by mass of toluene, and 0.6 parts by mass of 1,3-di(tert-butylisopropylbenzene) in a stainless-steel container, and stirring the resulting mixture for 1 hour at room temperature.

Each glass fabric obtained in Examples and Comparative Examples was made into a roll. From the thus obtained roll, the glass fabric was drawn out at a line speed of 2 m/min. In this process, the glass fabric was drawn out with a tension of 100 N being applied thereto. The thus drawn glass fabric was immersed in the above-obtained varnish while being transported, and subsequently passed through a slit whose gap was adjusted such that the resin content was 68% by mass, whereby excess varnish was removed. Thereafter, the resultant was dried at a drying temperature of 130°C for a drying time of 1 minute and 30 seconds. As a result, a prepreg was obtained (Examples and Comparative Examples).

<Amount of Meandering of Glass fabric During Prepreg Production>

In accordance with the conditions of the prepreg production, the glass fabric was drawn out from the roll at a line speed of 2 m/min with a tension of 100 N being applied thereto, and the amount of meandering of the glass fabric in this process was measured.

The following conditions are taken into consideration for the method of measuring the amount of meandering.

(1) A detector was arranged at a distance of about 10 cm from the roll, and the glass fabric was drawn out along the MD direction such that one end of the glass fabric passed through the detector.
(2) The glass fabric was drawn out over a length of about 500 m and, during this process, the amount of deviation in the width direction (TD) with respect to a prescribed reference value was detected by the detector. The amount of deviation of the fabric toward the outside was taken as a "positive (+) deviation amount" while the amount of deviation of the fabric toward the inside was taken as a "negative (-) deviation amount", and these amounts of deviation were each detected.
(3) A sum of the maximum value of the detected "positive (+) deviation amount" and the maximum value of the detected "negative (-) deviation amount" was calculated as the "amount of meandering."

<Yield of Prepreg>

From the thus obtained prepreg, samples having a size of 400 mm × 400 mm were cut out. After this sampling, samples observed with no wrinkles or fluff in visual inspection were defined as "good products", and the number thereof was counted to calculate the yield of the prepreg using the following equation:

$$\text{Yield of prepreg } (\%) = \{(\text{Number of good samples})/(\text{Number of samples})\} \times 100.$$

Regarding Examples and Comparative Examples, the production conditions, the evaluation results, and the like are shown in the table below.

In the table below, examining the relationship between "Amount of meandering" and "Yield", it was confirmed that the greater the "Amount of meandering" of the glass fabric, the lower the "Yield". This is presumably because a glass fabric having a greater "Amount of meandering" is more likely to cause the generation of wrinkles on a prepreg and thus lead to a reduction in the "Yield".

[Table 1]

Table 1

| | | | Example 1 | Example 2 | Example 3 | Example 4 | Example 5 | Example 6 | Example 7 | Example 8 | Example 9 | Example 10 | Comparative Example 1 | Comparative Example 2 | Comparative Example 3 |
|---|---|---|---|---|---|---|---|---|---|---|---|---|---|---|---|
| Thread count | Warp | yarns/25 mm | 65.0 | 65.0 | 65.0 | 65.0 | 52.6 | 52.6 | 52.6 | 52.6 | 65.0 | 65.0 | 65.0 | 65.0 | 65.0 |
| | Weft | yarns/25 mm | 66.9 | 66.9 | 66.9 | 66.9 | 52.6 | 52.6 | 52.6 | 52.6 | 66.9 | 66.9 | 66.9 | 66.9 | 66.9 |
| Warp yarn | Twist number | turns/25 mm | 1.00 | 1.00 | 1.00 | 1.00 | 1.00 | 1.00 | 1.30 | 1.00 | 1.00 | 1.00 | 1.00 | 1.00 | 1.00 |
| | TEX | g/1,000 m | 5.0 | 5.0 | 5.0 | 5.0 | 9.8 | 9.8 | 9.8 | 9.8 | 5.0 | 5.0 | 5.0 | 5.0 | 5.0 |
| Weft yarn | Twist number | turns/25 mm | 0.65 | 0.50 | 0.85 | 0.65 | 0.50 | 0.45 | 0.65 | 0.80 | 0.50 | 0.50 | 1.00 | 0.20 | 0.50 |
| | TEX | g/1,000 m | 5.0 | 5.0 | 5.0 | 5.0 | 9.8 | 9.8 | 9.8 | 9.8 | 5.0 | 5.0 | 5.0 | 5.0 | 5.0 |
| | Skew amount | mm | 18 | 19 | 16 | 14 | 19 | 14 | 14 | 17 | 33 | 28 | 15 | 22 | 36 |
| Absolute value difference in twist number | | g/1,000 m | 0.35 | 0.50 | 0.15 | 0.35 | 0.50 | 0.55 | 0.65 | 0.20 | 0.50 | 0.50 | 0.00 | 0.80 | 0.50 |
| Tension setting in warping | Center | g/yarn | 5.0 | 5.0 | 5.0 | 5.0 | 5.0 | 5.0 | 5.0 | 5.0 | 5.0 | 5.0 | 5.0 | 5.0 | 5.0 |
| | Both ends | g/yarn | 8.0 | 1.00 | 8.0 | 1.00 | 8.0 | 1.00 | 1.00 | 8.0 | 6.8 | 8.0 | 5.0 | 1.00 | 5.0 |
| | Taper amount | g/yarn | 0.007 | 0.012 | 0.007 | 0.012 | 0.009 | 0.014 | 0.014 | 0.009 | 0.004 | 0.007 | - | 0.012 | - |
| Glass fabric | Thickness | μm | 33 | 32 | 34 | 33 | 42 | 43 | 43 | 43 | 32 | 32 | 34 | 32 | 32 |
| | Fluff quality | | A | B | A | A | A | A | A | A | B | B | A | C | B |
| Smoothness (coefficient of variation in thickness) | | % | 3 | 3 | 8 | 3 | 3 | 3 | 3 | 5 | 3 | 3 | 11 | 2 | 3 |

(continued)

| | | Example 1 | Example 2 | Example 3 | Example 4 | Example 5 | Example 6 | Example 7 | Example 8 | Example 9 | Example 10 | Comparative Example 1 | Comparative Example 2 | Comparative Example 3 |
|---|---|---|---|---|---|---|---|---|---|---|---|---|---|---|
| Amount of meandering | mm | 10 | 10 | 9 | 5 | 10 | 5 | 5 | 7 | 28 | 25 | 5 | 17 | 32 |
| Yield of prepreg | % | 91 | 92 | 92 | 95 | 91 | 95 | 95 | 94 | 77 | 80 | 94 | 85 | 65 |

**Claims**

1.  A glass fabric, comprising glass yarns as warp yarns and weft yarns,

    wherein the weft yarns have a twist number of 0.40 to 1.80 turns/25 mm or -1.80 to -0.40 turns/25 mm,
    an absolute value difference in twist number between the warp yarns and the weft yarns is 0.01 to 0.70 turns/25 mm, and
    the weft yarns have a skew amount of 35 mm or less.

2.  The glass fabric according to claim 1, wherein a silicon (Si) content in the glass yarns is 95.0 to 100% by mass in terms of silicon dioxide ($SiO_2$).

3.  The glass fabric according to claim 1 or 2, wherein the silicon (Si) content in the glass yarns is 99.0 to 100% by mass in terms of silicon dioxide ($SiO_2$).

4.  The glass fabric according to claim 1 or 2, wherein the warp yarns have a twist number of 0.40 to 1.80 turns/25 mm or -1.80 to -0.40 turns/25 mm.

5.  The glass fabric according to claim 1 or 2, wherein the glass yarns are treated with a surface treatment agent containing a silane coupling agent.

6.  The glass fabric according to claim 5, wherein the surface treatment agent contains a silane coupling agent represented by the following Formula (1):

    $$X(R)_{3-n}SiY_n \qquad (1)$$

    (wherein, X represents an organic functional group having at least one of an amino group or a radical-reactive unsaturated double bond group; each Y independently represents an alkoxy group; n represents an integer of 1 to 3; and each R independently represents a group selected from the group consisting of functional groups composed of hydrocarbon groups having 1 to 10 carbon atoms).

7.  The glass fabric according to claim 6, wherein X in Formula (1) is an organic functional group not forming a salt with an ionic compound.

8.  The glass fabric according to claim 6, wherein X in Formula (1) does not contain an amine or an ammonium cation.

9.  The glass fabric according to claim 6, wherein X in Formula (1) is an organic functional group having one or more of at least one of a methacryloxy group or an acryloxy group.

10. The glass fabric according to claim 6, wherein R in Formula (1) is a group selected from the group consisting of a methyl group, an ethyl group, and a phenyl group.

11. The glass fabric according to claim 1 or 2, wherein the warp yarns and the weft yarns have a TEX of 0.5 to 40 g/1,000 m.

12. The glass fabric according to claim 1 or 2, wherein glass constituting the glass yarns has a bulk dielectric loss tangent in a range of 0.001 or less at 10 GHz.

13. The glass fabric according to claim 1 or 2, which is for a printed circuit board.

14. A prepreg, comprising:

    the glass fabric according to claim 1 or 2;
    a thermosetting resin; and
    an inorganic filler.

15. A printed circuit board, comprising the prepreg according to claim 14.

16. An integrated circuit, comprising the printed circuit board according to claim 15.

**17.** An electronic device, comprising the printed circuit board according to claim 15.

## INTERNATIONAL SEARCH REPORT

| International application No. |
|---|
| **PCT/JP2024/023361** |

**A. CLASSIFICATION OF SUBJECT MATTER**

**D03D 15/267**(2021.01)i; **C08J 5/24**(2006.01)i; **D03D 1/00**(2006.01)i; **D03D 15/41**(2021.01)i; **D06M 13/203**(2006.01)i; **D06M 13/513**(2006.01)i; **H05K 1/03**(2006.01)i

FI: D03D15/267; D03D15/41; D03D1/00 A; D06M13/513; D06M13/203; C08J5/24; H05K1/03 610T

According to International Patent Classification (IPC) or to both national classification and IPC

**B. FIELDS SEARCHED**

Minimum documentation searched (classification system followed by classification symbols)

D03D15/267; C08J5/24; D03D1/00; D03D15/41; D06M13/203; D06M13/513; H05K1/03

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 7-42045 A (NITTO BOSEKI CO., LTD.) 10 February 1995 (1995-02-10) claims, examples, paragraph [0012] | 1, 4-11, 13-17 |
| Y | | 1-17 |
| Y | JP 63-306030 A (ASAHI SCHWEBEL CO., LTD.) 14 December 1988 (1988-12-14) example 3, p. 1, lower right column | 1-17 |
| Y | JP 55-130764 A (SUMITOMO BAKELITE CO., LTD.) 09 October 1980 (1980-10-09) claims, examples | 1-17 |
| Y | JP 1-249333 A (NITTO BOSEKI CO., LTD.) 04 October 1989 (1989-10-04) claims, examples I, II | 1-3, 5-17 |
| Y | JP 11-241251 A (NITTO BOSEKI CO., LTD.) 07 September 1999 (1999-09-07) table 3 | 1-17 |

☑ Further documents are listed in the continuation of Box C.　　☑ See patent family annex.

| | | |
|---|---|---|
| * | Special categories of cited documents: | |
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| **12 September 2024** | **01 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**

| | International application No. |
|---|---|
| | **PCT/JP2024/023361** |

**C.    DOCUMENTS CONSIDERED TO BE RELEVANT**

| Category* | Citation of document, with indication, where appropriate, of the relevant passages | Relevant to claim No. |
|---|---|---|
| Y | JP 2019-183297 A (ASAHI KASEI KABUSHIKI KAISHA) 24 October 2019 (2019-10-24)<br>claims 3-6, examples | 1-17 |
| Y | WO 2022/215287 A1 (ASAHI KASEI KABUSHIKI KAISHA) 13 October 2022<br>(2022-10-13)<br>claims, examples | 2-3, 12 |

Form PCT/ISA/210 (second sheet) (July 2022)

**INTERNATIONAL SEARCH REPORT**
**Information on patent family members**

International application No.

**PCT/JP2024/023361**

| Patent document cited in search report | | | Publication date (day/month/year) | Patent family member(s) | | Publication date (day/month/year) |
|---|---|---|---|---|---|---|
| JP | 7-42045 | A | 10 February 1995 | (Family: none) | | |
| JP | 63-306030 | A | 14 December 1988 | (Family: none) | | |
| JP | 55-130764 | A | 09 October 1980 | (Family: none) | | |
| JP | 1-249333 | A | 04 October 1989 | (Family: none) | | |
| JP | 11-241251 | A | 07 September 1999 | US 6283166 B1 table 3 US 2002/0028622 A1 WO 1999/041441 A1 EP 985756 A1 KR 10-2001-0006226 A | | |
| JP | 2019-183297 | A | 24 October 2019 | JP 2022-63290 A | | |
| WO | 2022/215287 | A1 | 13 October 2022 | US 2024/0121894 A1 claims, examples JP 7015973 B1 KR 10-2023-0129501 A CN 117136261 A TW 202240040 A | | |

Form PCT/ISA/210 (patent family annex) (July 2022)

**REFERENCES CITED IN THE DESCRIPTION**

**Patent documents cited in the description**

- WO 2019065940 A
- WO 2019065941 A

- JP 2016011484 A